Europäisches Patentamt

**European Patent Office**

**Office européen des brevets**

(19)

(11) Publication number: **0 173 465**
A2

## (12) EUROPEAN PATENT APPLICATION

(21) Application number: **85305438.5**

(22) Date of filing: **30.07.85**

(51) Int. Cl.⁴: **H 01 J  37/305,** H 01 L  21/263,
H 01 L  21/20

(30) Priority: **31.07.84  US 636395**

(71) Applicant: **Rocca, Jorge J., 942 Driftwood Drive, Fort Collins Colorado 80525 (US)**
Applicant: **Collins, George J., 807 West Oak, Fort Collins Colorado 80521 (US)**
Applicant: **Moore, Cameron A., 2931 Virgian Dale Drive, Fort Collins Colorado 80521 (US)**

(43) Date of publication of application: **05.03.86**
**Bulletin 86/10**

(72) Inventor: **Rocca, Jorge J., 942 Driftwood Drive, Fort Collins Colorado 80525 (US)**
Inventor: **Collins, George J., 807 West Oak, Fort Collins Colorado 80521 (US)**
Inventor: **Moore, Cameron A., 2931 Virgian Dale Drive, Fort Collins Colorado 80521 (US)**

(74) Representative: **Oliver, Peter A., 8 Coombe Close, Frimley Surrey GU16 5DZ (GB)**

(84) Designated Contracting States: **DE FR GB NL**

(54) **Glow discharge electron beam method and apparatus for the surface recrystallization of solid substances.**

(57)  The recrystallization of polycrystalline or amorphous materials commonly used as semiconductor substrates is accomplished by employing as a heat source a cold cathode, glow discharge electron beam gun (24) that emits a sharply focussed line electron beam (10) arranged to impinge on a moving substrate material (19). The method yields large surface areas that are substantially free from defects with minimum subsurface heating and rapid throughput.

EP 0 173 465 A2

1

## GLOW DISCHARGE ELECTRON BEAM METHOD AND APPARATUS FOR THE SURFACE RECRYSTALLIZATION OF SOLID SUBSTANCES

The semiconductor industry is sometimes hindered by the lack of a cost effective production method to bring a new and useful technology into use. A recent example is fabrication of the silicon-on-insulator material (SOI), whose properties are important in connection with three dimensional, very-high-speed integrated circuits, large area displays required by the manufacturers of next generation computers and television sets, and other devices. The high film quality required to perform some of these functions would ideally have as few crystal defects as possible. The problems associated with SOI fabrication include silicon film quality, throughput, and process temperature. The quality of the silicon film required varies among different applications. The trend for all applications however, is for higher film quality. The quality of the film is determined by the number of defects (principally grain boundaries) found in a given area. A small number of grain boundaries implies that the average size of individual crystal grains is large. A high quality film has large grains. For instance, a perfect single crystal film consists of only one grain. The current methods for fabrication of the SOI structure, such as dielectric isolation or epitaxy, suffer from low yield, low throughput, or require high temperature processing. The preferred method under intensive investigation by semiconductor companies world wide is recrystallization. In this method an insulator substrate is coated with an amorphous or polysilicon film which in turn is exposed to a heat source that will scan rapidly across the film. The silicon film melts locally and this molten zone or front is translated with the heat source across the substrate, leaving a film with a higher quality crystal structure. A line heat source is one which produces a narrow melted zone which can be as wide as the substrate, but is sharply focused, resulting in a very narrow line at the surface of the substrate. This line of melted silicon can be translated fairly rapidly across the length of a substrate. Alternatively, a spot source produces a melted zone at a small point on the substrate and must be raster scanned over the entire surface thereof. Four current heat sources have been investigated for use in a recrystallization process. The first such source was a graphite strip heater. This source is heated electrically to a very high temperature and the radiant heat melts the silicon film. It is a line source of broad focus and can translate over the entire substrate in a single pass. However, the melt depth of the silicon film and the focus area are large, and the process produces low quality films. The slow molten zone velocity (typically 1 milli-meter/second) and high temperatures (1000-1400 degrees C) render this technique incapable of processing multiple film layers without causing catastrophic failure of electronic devices located on film layers below the SOI surface film layer.

The second heat source investigated was an argon laser. The laser is a spot source which has the advantage of a shallow melt depth in silicon. This source cannot be converted into a line source by any practical means. The spot must be scanned by overlapping passes over the structure, with resultant marginal film quality and low process throughput.

The third heat source investigated was spot electron beam. This source is very expensive and requires ultra-high vacuum conditions for operation. The melt depth is very

3    0173465

large as a result of the necessarily high-energy electrons emitted to achieve recrystallization.  The overlapping scans of this spot source limit the throughput and result in a low quality film.

The last heat source investigated was the line source thermionic cathode electron beam.  This source also needs to operate in ultra high vacuum conditions.  It is also limited in line length and electron beam pulse duration. Several scans are needed to recrystallize a 10 or 15 cms diameter substrate, resulting in a lower quality recrystallized film.

The present invention provides apparatus for the recrystallization of a solid substance, the apparatus being characterized by a direct current glow discharge electron beam gun for producing a focussed line electron beam; chamber means surrounding the direct current glow discharge electron beam gun and the solid substance to be recrystallized to provide a controlled gas environment; means for controlling the energy, current, and time dependence of the focussed line electron beam; means for movably supporting the solid substance transverse to a path of said focussed line electron beam; means for selecting, admitting, and controlling the partial pressures of one or more gases in said chamber means; and vacuum pump means for circulating the one or more gases through said chamber means.

In apparatus as set forth in the last preceding paragraph, it is preferred that said focussed line electron beam is focussed on a surface of said solid substance.

In apparatus as set forth in either one of the last two immediately preceding paragraphs, it is preferred that said solid substance includes one or more film layers and said focussed line electron beam is focussed on a selected one of said one or more film layers.

In apparatus as set forth in any one of the last three immediately preceding paragraphs, it is preferred that said direct current glow discharge electron beam gun comprises a cathode element of aluminium, magnesium or a sintered mixture of a metal and particles of a metal oxide.

In apparatus as set forth in any one of the last four immediately preceding paragraphs, it is preferred that said direct current glow discharge electron beam gun comprises a generally cylindrically-shaped cathode element having a longitudinally-extending notch of generally rectangular cross-section on the surface thereof for defining an electron emitting surface of said cathode element, said direct current glow discharge electron beam gun further including longitudinally-extending metal conductor means positioned proximate to said electron emitting surface for defining a longitudinally-extending electron beam aperture and for focussing electrons emitted from said electron emitting surface into a very narrow straight line electron beam at a predetermined distance from said electron emitting surface, the length of said line electron beam being substantially equal to the length of said longitudinally-extending notch and of said longitudinally-extending electron beam aperture.

In apparatus as set forth in the last preceding paragraph, it is preferred that a longitudinal axis of said longitudinally-extending notch of said cathode element and a longitudinal axis of said longitudinally-extending metal conductor means are coincident with a line of curvature, whereby electrons emitted from said electron emitting surface are focussed into a very narrow curved line electron beam at a predetermined distance from said electron emitting surface.

In apparatus as set forth in any one of the last six immediately preceding paragraphs, it is preferred that said means for movably supporting the solid substance transverse to said focussed line electron beam is operative for moving the solid substance across said focussed line electron beam at a non-uniform speed.

In apparatus as set forth in any one of the last seven immediately preceding paragraphs, it is preferred that said means for controlling the energy, current, and time dependence of the focussed line electron beam is operative for varying the energy of the focussed line electron beam during recrystallization of the solid substance.

In apparatus as set forth in any one of the last eight immediately preceding paragraphs, it is preferred that one of said one or more gases is selected from helium, hydrogen and oxygen.

Apparatus as set forth in any one of the last nine immediately preceding paragraphs, may be further characterized by means for electrically biasing said solid substance at a selected electrical potential.

In apparatus as set forth in any one of the last ten immediately preceding paragraphs, it is preferred that said solid substance includes a surface film comprising polycrystalline silicon or amorphous hydrogenated silicon.

The present invention further provides apparatus for the recrystallization of a solid substance, the apparatus being characterized by a direct current glow discharge electron beam gun for producing a focussed line electron beam; chamber means surrounding the direct current glow discharge electron beam gun and the solid substance to be recrystallized to provide a controlled gas environment; means for controlling the energy, current, and time dependence of the focussed line electron beam; means for supporting the solid substance; means coupled to the direct current glow discharge electron beam gun for scanning the focussed line electron beam across a surface of said solid substance; means for selecting, admitting, and controlling the partial pressures of one or more gases in said chamber means; and vacuum pump means for circulating the one or more gases through said chamber means.

The present invention further provides apparatus for the repair of an ion implanted substrate, the apparatus comprising a direct current glow discharge electron beam gun for producing a focussed line electron beam; chamber means surrounding the direct current glow discharge electron beam gun and the ion implanted substrate to provide a controlled gas environment; means for controlling the energy, current, and time dependence of the focussed line electron beam; means for movably supporting the ion implanted substrate transverse to said focussed line electron beam; means for selecting, admitting, and controlling the partial pressures of one or more gases in said chamber means; and vacuum pump means for circulating the one or more gases through said chamber means.

The present invention further provides a method of employing a focussed line electron beam to recrystallize a solid substance, or to anneal damage to an ion implanted substrate, the method comprising the steps of establishing a controlled gas atmosphere in an evaculated chamber; producing a focussed line electron beam having a length at least as great as a length of the solid substance or ion implanted substrate; and effecting relative movement of the solid substance or ion implanted substrate across the focussed line electron beam, whereby a surface of the substance or substrate is melted.

Preferably, the steps of establishing a controlled gas atmosphere in the evacuated chamber and effecting relative movement of a surface of the solid substance or the ion implanted substrate across the focussed line electron beam are sequentially repeatedly performed.

The novel glow discharge line source electron beam gun of apparatus according to the present invention eliminates all of the problems associated with the four prior art heat sources described above. The length of the beam is greater than the wafer diameter and, consequently, an entire wafer can be processed in a single scan.   This feature increases film quality and throughput and is a unique feature of our glow discharge electron beam source.   Direct current (D.C.) cold cathode, glow discharge electron beam guns of apparatus according to the present invention have fundamental properties which make them ideally suited for the surface recrystallization of semiconductor substrates.   By tailoring the electron gun geometry, the beam can be focussed into a very narrow line of arbitrary length with high beam homogeneity. The energy density per unit area can be easily controlled over a wide range without affecting the narrow beam focus quality due to the absence of space charge.   These previously unattainable electron beam properties allow operator selection of the beam properties most cost effective for a given throughput and film quality.   The process is carried out in pressure vessels having a controlled partial pressure of a suitable gas such as helium, hydrogen or mixtures thereof.   In the case of helium, the typical operating pressures are between 0.1 and 2 Torr.   Other gases may be present in controlled amounts.   This is in contrast with other known electron guns employed for recrystallization that need to operate in a high vacuum atmosphere (less than $10^{-14}$), thus increasing the system cost and decreasing throughput.   The present electron beam gun is arranged so that the focus of the line beam is positioned on the surface of the substrate to be treated.   When the beam is adjusted to have the necessary properties such as power density and focus required for recrystallization of a given substrate material, the beam scans the substrate by mechanical translation of the supporting stage holding the substrate, or alternatively, by mechanically translating the electron beam gun.   Adjustment of the scan rate controls the depth of molten material produced by the electron beam and the propagation speed of the molten front.   The apparatus of the present invention can typically recrystallize the surface of a 10 cms silicon wafer in a few seconds or less without raising the underlying substrate structure to unacceptably high temperatures. The same apparatus can be used to repair ion implantation damage in wafers by lowering the electron beam power and/or increasing the substrate scanning speed. This occurs without significant redistribution of the dopants. For typical annealing processes, the electron beam is operated at a lower power density to prevent melting of the wafer.

There now follows a detailed description which is to be read with reference to the accompanying drawings of apparatus according to the present invention; it is to be clearly understood that this apparatus has been selected for description to illustrate the invention by way of example and not by way of limitation.

In the accompanying drawings:-

Figure 1 is a diagram illustrating in cross-section a preferred embodiment of a cold cathode, glow discharge electron beam gun suitable for employment in an apparatus according to the present invention;

Figure 2 is a detailed diagram of a portion of the cold cathode, glow discharge electron beam gun of Figure 1 illustrating the cathode shape and beam shaping conductor at the gun aperture used to provide a focussed electron beam; and

Figure 3 is a diagram illustrating an apparatus according to the present invention for recrystallizing films that employs the cold cathode, glow discharge electron beam gun of Figures 1 and 2.

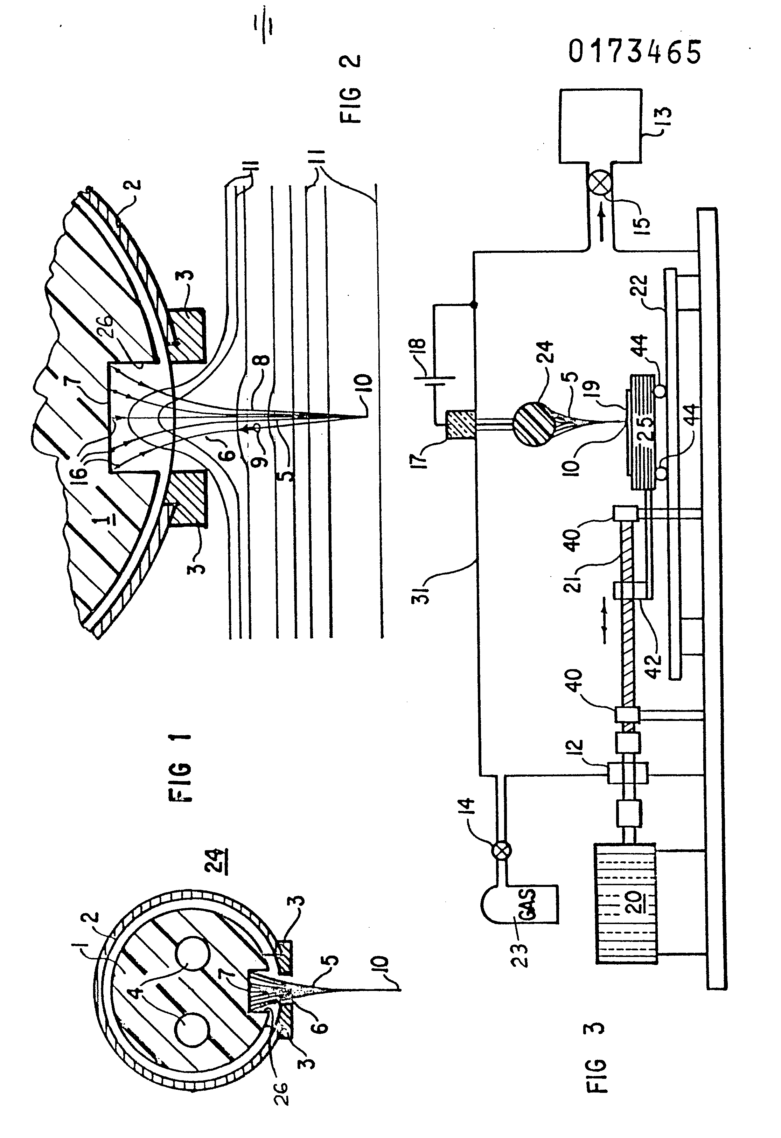

Referring now to Figure 1, there is shown the cross-section of a cold cathode, glow discharge electron beam gun that includes s cylindrical cathode 1, having an elongate notch 26 formed therein, that is fabricated from a material selected for its favourable secondary electron emission properties and its resistance to erosion by ion bombardment;

examples of such materials are aluminium and magnesium. These materials, when covered by a thin oxide layer, are suitable for use as a cathode in an electron gun that is capable of producing a multi-kilowatt electron beam. In order to maintain the oxide layer during operation, it is necessary to operate the electron gun in an atmosphere having a partial pressure of oxygen. A sintered mixture of metal and metal oxide powder, such as molybdenum and aluminium oxide, may also be employed as the cathode material, in which case a partial pressure of oxygen is not required. If desired, an electron gun having such a cathode may be operated in a pure noble gas atmosphere. The generation efficiencies of electron beams produced by electron guns employing such cathodes may be as high as eighty percent (80%). The cathode 1 is shielded by a tube 2 that effectively limits the emission of electrons to the unshielded cathode surface 7 through the aperture 5 that is formed by a metal conductor 3. The distance between the cathode 1 and the tube 2 is preferably sufficiently small to inhibit electron emission from all other cathode surfaces. The cathode 1 is maintained near room temperature by circulating coolant through cooling fluid ducts 4 that are embedded or bored in the cathode 1. The entire electron beam gun structure 24 is immersed in a controlled gas environment provided by a pressure vessel 31 shown in Figure 3. A D.C. high voltage source 18 initiates a discharge between the cathode (negative connection) and the pressure vessel 31 (positive connection) via the ionized gas contained within the pressure vessel 31.

Referring now to Figure 2, there is shown an expanded cross-section of the electron emitting and focussing region of the electron beam gun 24 illustrated in Figure 1. In particular, Figure 2 illustrates the equipotential lines 11 and the perpendicular electric field lines 8 that are responsible for achieving the desired focussing of the emitted electron beam.

The physical mechanism for the generation of an electron beam 5 from the cold cathode, glow discharge electron beam gun of the present invention is based upon the secondary electrons 16 produced by ions 9 bombarding the unshielded cathode surface 7 provided by the notch 26. The ions 9, being positively charged, are accelerated toward the negatively charged cathode 1. Upon striking the cathode 1, the kinetic energy of the ions 9 releases one or more electrons 16 from the unshielded cathode surface 7. As a result, the ions 9 become neutral atoms. The electrons 16, being negatively charged, are accelerated away from the cathode, along the electric field lines 8. The cathode 1 is formed so that its emitting surface comprises a rectangular slot defined by the unshielded cathode surface 7 to cause the electric field lines 8, and hence the emitted electrons 16, to converge into a sharply focussed line electron beam 10. The length of the sharply focussed line electron beam 10 is a function of the length of the aperture 6 along the longitudinal axis of the electron beam gun 24. The rectangular notch 26 defining the unshielded cathode surface 7 may be curved longitudinally along with the metal conductor 3 to impart a longitudinal curvature to the aperture 6 and consequently to the sharply focussed line electron beam 10 emitted therefrom. This longitudinal curvature of the sharply focussed line electron beam 10 may be effective in producing desired thermal gradients in the recrystallized film to reduce film defects. Since there are substantially equal numbers of positively charged ions 9 and negatively charged electrons 16, there is no net space charge in the volume occupied by the electron beam 5. Thus, it is possible to accurately focus an electron beam having a kilovolt energy level to an arbitrarily narrow line beam 10. The shaping of the equipotential lines 11 that is responsible for the convergence of the emitted electron beam 5 is accomplished by the relative geometrical shape and position of the rectangular notch 26 defining the unshielded cathode surface 7 with respect to the aperture 6 formed by the metal conductor 3. This strucure is arranged by taking into consideration the fact that a corductor is equipotential and that the equipotential lines in the ionized gas in the vicinity of a conductor will closely follow the contour of that conductor. The capability of delivering controllable power densities of the order of several kilowatts per square centimetre in a sharply focussed line electron beam at relatively low electron energies is an important feature of the present invention.

Referring now to Figure 3, there is shown an apparatus for recrystallizing films that employs the cold cathode, glow discharge electron beam gun 24 illustrated in Figures 1 and 2 and described above. The essential structural features of this apparatus are combined as illustrated to cause the sharply focussed line electron beam 10 emitted by the cold cathode, glow discharge electron beam gun described above to impinge on a wafer 19 that consists of a substrate and a polycrystalline film. A temperature controlled support stage 25 provides support for the wafer 19 and includes a number of rollers 44 that permit translational motion of the support stage 25, along a guide rail 22, orthogonal to the sharply focussed line electron beam 10. The support stage 25 is arranged to be translated at controlled speeds by a mechanism that includes a motor 20 and a threaded lead screw 21, mounted in support bearings 40, to impart translational motion to a carrier 42 that is coupled to the support stage 25. A typical translation rate for wafers having silicon films is about 2.5 cms per second. The entire structure is enclosed in the pressure vessel 31, except the motor 20, which is coupled to the lead screw 21 by way of a vacuum-tight rotary coupling 12. The interior gas composition and pressure within the pressure vessel 31 are controlled in a conventional way by a vacuum pump 13 and a gas inlet flow regulator 14 controlling supply of gas from a gas supply 23. Typical operating pressures range from a fraction of a Torr to several Torr of helium or hydrogen or mixtures thereof. The electron beam gun 24 is connected to the high voltage source 18 by way of a high voltage feed-through 17, the voltage source being capable of controlling the energy and current of the electron beam.

The operating sequence for recrystallizing a film of the wafer 19 is to index the support stage 25 at one edge of the wafer 19 where the sharply focussed line electron beam converges. The pressure vessel 31 is evacuated to a desired level by activating the vacuum pump 13. When a desired vacuum level has been obtained, a controlled gas atmosphere is established by the combination of the inlet flow regulator 14 and a throttle valve 15 associated with the vacuum pump 13. The high voltage source 18 is then turned on and the applied voltage is adjusted to a desired level. The motor 20 is then turned on to begin translational motion of the support stage 25 and the wafer 19. The sharply focussed line electron beam 10 melts the film on the wafer 19. As the wafer 19 moves, the molten front traverses the wafer and recrystallizes upon cooling. If desired, the wafer 19 may be multiply passed across the sharply focussed line electron beam 10 under similar or different beam powers, gas mixtures or pressures, and translational speeds thereof to generally improve the quality of the recrystallized film. For example, a second pass may be performed in an atmosphere containing hydrogen to passivate grain boundaries. Additionally, the wafer or substrate 19 can be held at a desired potential to control the effect of the electron beam. The electrical bias of the wafer or substrate will affect the energy of the electron beam and thus influence the effectiveness thereof.

0173465

CLAIMS

1. Apparatus for the recrystallization of a solid substance, the apparatus being characterized by:-

a direct current glow discharge electron beam gun (24) for producing a focussed line electron beam (10);

chamber means (31) surrounding the direct current glow discharge electron beam gun and the solid substance to be recrystallized to provide a controlled gas environment;

means (18) for controlling the energy, current, and time dependence of the focussed line electron beam;

means (20,21,25) for movably supporting the solid substance transverse to a path of said focussed line electron beam;

means (14,15) for selecting, admitting, and controlling the partial pressures of one or more gases in said chamber means; and

vacuum pump means (13) for circulating the one or more gases through said chamber means.

2. Apparatus according to claim 1 characterized in that said focussed line electron beam (10) is focussed on a surface of said solid substance (19).

3. Apparatus according to either one of claims 1 and 2 characterized in that said solid substance (19) includes one or more film layers and said focussed line electron beam is focussed on a selected one of said one or more film layers.

4. Apparatus according to any one of the preceding claims characterized in that said direct current glow discharge electron beam gun (24) comprises a cathode element (1) of aluminium, magnesium or a sintered mixture of a metal and particles of a metal oxide.

5. Apparatus according to any one of the preceding claims characterized in that said direct current glow discharge electron beam gun (24) comprises a generally cylindrically-shaped cathode element (1) having a longitudinally-extending notch (26) of generally rectangular cross-section on the surface thereof for defining an electron emitting surface (7) of said cathode element, said direct current glow discharge electron beam gun further including longitudinally-extending metal conductor means (3) positioned proximate to said electron emitting surface for defining a longitudinally-extending electron beam aperture (6) and for focussing electrons emitted from said electron emitting surface into a very narrow straight line electron beam (10) at a predetermined distance from said electron emitting surface, the length of said line electron beam being substantially equal to the length of said longitudinally-extending notch (26) and of said longitudinally-extending electron beam aperture (6).

6. Apparatus according to claim 5 characterized in that a longitudinal axis of said longitudinally-extending notch of said cathode element and a longitudinal axis of said longitudinally-extending metal conductor means (3) are coincident with a line of curvature, whereby electrons emitted from said electron emitting surface (7) are focussed into a very narrow curved line electron beam at a predetermined distance from said electron emitting surface.

7. Apparatus according to any one of the preceding claims characterized in that said means (20,21,25) for movably supporting the solid substance (19) transverse to said focussed line electron beam (10) is operative for moving the solid substance across said focussed line electron beam at a non-uniform speed.

8.    Apparatus according to any one of the preceding claims characterized in that said means for controlling the energy, current, and time dependence of the focussed line electron beam (10) is operative for varying the energy of the focussed line electron beam during recrystallization of the solid substance.

9.    Apparatus according to any one of the preceding claims characterized in that one of said one or more gases is selected from helium, hydrogen and oxygen.

10.    Apparatus according to any one of the preceding claims and further characterized by means for electrically biasing said solid substance at a selected electrical potential.

11.    Apparatus according to any one of the preceding claims characterized in that said solid substance includes a surface film comprising polycrystalline silicon or amorphous hydrogenated silicon.

12.    Apparatus for the recrystallization of a solid substance, the apparatus being characterized by:-
        a direct current glow discharge electron beam gun (24) for producing a focussed line electron beam (10);
        chamber means (31) surrounding the direct current glow discharge electron beam gun (24) and the solid substance (19) to be recrystallized to provide a controlled gas environment;
        means (18) for controlling the energy, current, and time dependence of the focussed line electron beam;
        means (25) for supporting the solid substance;
        means coupled to the direct current glow discharge electron beam gun for scanning the focussed line electron beam across a surface of said solid substance;

means (14,15) for selecting, admitting, and controlling the partial pressures of one or more gases in said chamber means; and

vacuum pump means (13) for circulating the one or more gases through said chamber means.

13. Apparatus for the repair of an ion implanted substrate, the apparatus comprising:

a direct current glow discharge electron beam gun (24) for producing a focussed line electron beam (10);

chamber means (31) surrounding the direct current glow discharge electron beam gun and the ion implanted substrate to provide a controlled gas environment;

means (18) for controlling the energy, current, and time dependence of the focussed line electron beam (10);

means (14,15) for selecting, admitting, and controlling the partial pressures of one or more gases in said chamber means; and

vacuum pump means (13) for circulating the one or more gases through said chamber means.

14. A method of employing a focussed line electron beam to recrystallize a solid substance or to anneal damage to an ion implanted substrate, the method comprising the steps of:

establishing a controlled gas atmosphere in an evacuated chamber (31);

producing a focussed line electron beam (10) having a length at least as great as a length of the solid substance or ion implanted substrate; and

effecting relative movement of the solid substance or ion implanted substrate across the focussed line electron beam, whereby a surface of the substance or substrate is melted.

**0173465**

15.    A method according to claim 14 characterized in that the steps of establishing a controlled gas atmosphere in the evacuated chamber and effecting relative movement of a surface of the solid substance or the ion implanted substrate across the focussed line electron beam are sequentially repeatedly performed.

FIG 1

FIG 2

FIG 3